# EUROPEAN PATENT SPECIFICATION

(11) **EP 2 660 651 B1**
(45) Date of publication and mention of the grant of the patent: **31.01.2018**
(21) Application number: 12837626.6
(22) Date of filing: 23.12.2012
(51) Int. Cl.: G02F 1/1362, G02F 1/1343, G02F 1/133

(54) **ARRAY SUBSTRATE, MANUFACTURING METHOD THEREFOR AND DISPLAY DEVICE**
ARRAYSUBSTRAT, ZUGEHÖRIGES HERSTELLUNGSVERFAHREN UND ANZEIGEVORRICHTUNG
SUBSTRAT DE MATRICE, SON PROCÉDÉ DE FABRICATION ET DISPOSITIF D'AFFICHAGE

(30) Priority: 28.02.2012 CN 201210048847
(43) Date of publication of application: 06.11.2013
(73) Proprietor: BOE Technology Group Co., Ltd., Beijing 100015 (CN)
(72) Inventor: SONG, Youngsuk, Beijing 100176 (CN); HUI, Guanbao, Beijing 100176 (CN); YOO, Seongyeol, Beijing 100176 (CN); CHOI, Seungjin, Beijing 100176 (CN); ZHANG, Feng, Beijing 100176 (CN)
(74) Representative: Klunker IP Patentanwälte PartG mbB
(86) International application number: PCT/CN2012/087234
(87) International publication number: WO 2013/127236

(56) References cited:
- CN-A- 1 525 224
- CN-A- 101 770 116
- CN-A- 101 968 590
- CN-A- 102 681 276
- CN-U- 202 084 547
- JP-A- 2001 066 617
- JP-A- 2009 139 853
- US-A1- 2002 140 891
- US-A1- 2007 284 627
- US-A1- 2011 134 353

## Description

### BACKGROUND

Embodiments of the invention relate to an array substrate, a manufacturing method of the array substrate and a display device.

Thin film transistor liquid crystal display (TFT-LCD) has advantages of small volume, low power consumption, free of radiation and the like, and occupies a dominant role in current panel display market. With the progress of technology, the consumers have a higher demand on the display effect of mobile products, and the display effect of a normal twisted nematic (TN) type liquid crystal display can not meet such demand any more. At present, many manufacturers have applied various wide viewing angle mode, which have a better display effect, to mobile products, such as in-plane switching (IPS) mode, vertical alignment (VA) mode, advanced-super dimensional switching (AD-SDS, ADS for short) mode and the like. In the ADS mode, a multi-dimensional electric field is formed with both an electric field generated at edges of slit electrodes in a same plane and an electric field generated between a slit electrode layer and a plate-like electrode layer, so that liquid crystal molecules at all orientations, which are located directly above the electrodes or between the slit electrodes in a liquid crystal cell, can be rotated, In this way, the work efficiency of liquid crystal can be enhanced and the light transmittance can be increased. The ADS mode can improve the image quality of the thin film transistor liquid crystal display and has advantages of high transmittance, wide viewing angle, high aperture ratio, low chromatic aberration, high response speed, free of push Mura, etc.

In recent years, the application of liquid crystal display device to mobile phone, personal digital assistant (PDA), flat panel computer and the like gradually increases, and the liquid crystal display device is more and more applied to the outdoor mobile products. However, the normal liquid crystal display device has a poor contrast when being used outdoors under the sunlight so that the readability of the screen is not good. In contrast, the liquid crystal display device with trans-reflective structure can increase the contrast of the display device used outdoors by increasing the reflectivity of the panel, so that the display device with trans-reflective structure can maintain an excellent readability even when being used outdoors. Thus, the wide viewing angle trans-reflective TFT-LCD, which has an excellent display effect and can maintain an excellent readability outdoors, is a development trend of mobile products.

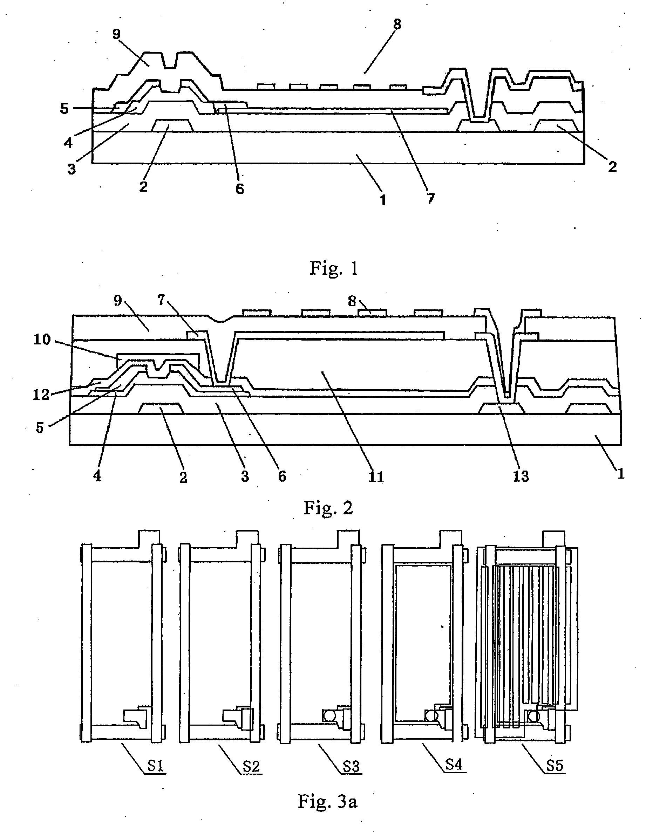

Fig. 1 shows a structure of a conventional TFT array substrate in an ADS mode. The array substrate comprises a gate line and a data line which define a pixel region, and the pixel region comprises a thin film transistor region and an electrode pattern region. A gate electrode 2, a gate insulation layer 3, an active layer 4, a source electrode 5, a drain electrode 6 and a passivation layer 9 are formed in the thin film transistor region. The gate insulation layer 3, a pixel electrode 7, the passivation layer 9 and a common electrode 8 are formed in the electrode pattern region. The common electrode 8 and the pixel electrode 7 form a multi-dimension electric field. This array substrate is applied to the liquid crystal display device, and the liquid crystal display device further comprises a color filter substrate and a back light source in addition to the array substrate. Generally, the array substrate and the color filter substrate are manufactured separately, then the array substrate and the color filter substrate are bonded together by a cell assembly process to form a display panel, and finally the display device is formed by a module process.

However, since the TFT region having a different thickness (as shown in Fig. 1, the passivation layer 9 has an obvious protrusion at the TFT) influences the filling uniformity of the liquid crystal molecules after the cell assembly process, there exists an irregular arrangement of the liquid crystal molecules in the reflective region. In addition, since the pixel electrode is relatively close to the data line, it may be influenced by the voltage of the data line, which is disadvantageous to horizontal driving of the ADS mode. In this case, light leakage may occur because the abnormal liquid crystal driving may cause the rotation angle of the liquid crystal molecules not sufficient. The light from the back light source may not be fully utilized in the display region due to the light leakage, thus the contrast may be reduced, and the display quality may be decreased.

US 2011/0134353 A1 discloses an FFS type horizontal electrical field liquid crystal display, in which an electrical field is applied to a liquid crystal material right above a common electrode and a pixel electrode using plural pairs of electrodes rather than one pair of electrodes. One pair of electrodes includes a comb-shaped common electrode and a comb-shaped pixel electrode. Another pair of electrodes includes a common electrode provided in a pixel portion and the comb-shaped pixel electrode.

US 2007/0284627 A1 discloses a LCD having a first electrode formed over a substrate, an insulating film formed over the substrate and the first electrode, a thin film transistor including a semiconductor film in which a source, a channel region, and a drain are formed over the insulating film, a second electrode located over the semiconductor film and the first electrode and including first opening patterns, and liquid crystals provided over the second electrode, by increasing the interval between the electrodes which drive the liquid crystals, a gradient of the electric field applied between the electrodes can be controlled and an optimal electric field can be applied between the electrodes.

US 2002/0140891 A1 discloses a LCD comprising one pair of substrates which are a first substrate and a second substrate, at least one of which is transparent, a liquid crystal layer and a color filter layer provided between the two substrates, a plurality of thin film transistors provided on the first substrate and connected to an image signal wiring and a scanning signal wiring, a common electrode giving a standard potential, and a pixel electrode connected to the thin film transistors and placed opposite to the common electrode in a pixel region, wherein the common electrode and pixel electrode are placed in different layers from each other through an inter-laminar insulating film in the form of layer comprising at least two layers comprising the color filter layer.

JP 2001-066617 A discloses a LCD device produced by forming scanning lines, gate electrodes, signal lines and thin film transistors on a transparent first substrate, forming color filters as an upper layer all over the substrate including the aforementioned elements, forming an overcoat layer on the color filters, and arranging pixel electrodes and common electrodes in the same layer on the overcoat layer.

### SUMMARY

It is an object of the present invention to provide an array substrate by which light leakage due to abnormal liquid crystal driving causing an insufficient rotation angle of the liquid crystal molecules is reduced so that light from a back light source may be better utilized in the display region, increasing contrast and display quality.

The object is achieved by the features of the respective independent claims. Further embodiments are defined in the respective dependent claims.

According to the embodiments of the invention, since the color resin layer is formed above the gate insulation layer, the distance between the pixel electrode and the data line or the gate line is increased (that is, the interlayer thickness is increased), and thus it is advantageous to make the pixel region to be more flat and prevent the pixel electrode from being influenced by the voltages of the data line and the gate line. Accordingly, the irregular arrangement of the liquid crystal molecules in the reflective region can be prevented, the ADS mode of horizontal driving can be maintained, the proper rotation of the liquid crystal molecules can be ensured, the light leakage can be avoided and the contrast can be improved.

According to the embodiments of the invention, the reflective region pattern is formed by using the metal material for the gate electrode, and the reflective region metal electrode layer is formed by using the metal material for the source and drain electrodes, and the color resin layer is formed on the reflective region metal electrode layer. It is also advantageous to increase the distance between the pixel electrode and the reflective region electrode layer, thus the light leakage caused by the irregular arrangement of the liquid crystal molecules in the reflective region can be prevented. In addition, the disposition of the reflective region (i.e. employing a trans-reflective manner) makes the liquid crystal display device to be able to enhance display effect under a strong light by using extern light, and thus the product quality can be improved and manufacturing cost can be reduced.

According to the embodiments of the invention, since it does not need to bond the array substrate with a separate color filter substrate, the liquid crystal molecules simply is filled between the array substrate and a glass substrate, and thus the alignment difficulty can be reduced. Meanwhile, since the common electrode is connected with the bottom electrode of the storage capacitance through a via hole in the insulation layer, a high aperture ratio can be obtained and the transmittance can be increased.

### BRIEF DESCRIPTION OF DRAWINGS

In order to describe the technical solutions of the embodiments of the invention, it will give a brief description to the figures of the embodiments below. Obviously, the below described figures are only relate some embodiments of the invention, and not intended to restrict the invention.
Fig. 1 is a schematic view showing a conventional array substrate in an ADS mode;
Fig. 2 is a schematic view showing an array substrate according to a first embodiment of the invention;
Fig. 3a and Fig. 3b are schematic views showing a method of manufacturing the array substrate according to the first embodiment of the invention; and
Fig. 4 is a schematic view showing an array substrate according to a second embodiment of the invention.

### DETAILED DESCRIPTION

In order to make aims, technical solution and advantages of the embodiments of the invention to be clearer, the technical solutions of the embodiments of the invention will be described below clearly and fully in connection with the figures of the embodiments of the invention. Obviously, the described embodiments are a portion of the embodiments of the invention, not to be all embodiments. Based on the described embodiments of the invention, all additional embodiments, which could be obtained by those skilled in the art without paying creative work, belong to the scope of the protection of the invention.

### First Embodiment

The present embodiment provides an array substrate, which may employ the ADS mode. As shown in Fig. 2, the array substrate comprises a gate line and a data line which define a pixel region, and the pixel region comprises a thin film transistor region and an electrode pattern region. A gate electrode 2, a gate insulation layer 3, an active layer 4, a source electrode 5, a drain electrode 6, and a passivation layer 9 are formed in the thin film transistor region. The gate insulation layer 3, a pixel electrode 7, the passivation layer 9 and a common electrode 8 are formed in the electrode pattern region. The common electrode 8 and the pixel electrode 7 may form a multi-dimensional electric field. Alternatively, a protection layer 12 may be formed on the gate insulation layer 3, the source electrode 5 and the drain electrode 6, and subsequently, a black matrix layer 10 may be formed above the source electrode 5, the drain electrode 6 and a TFT channel. Alternatively, the black matrix layer 10 may be directly formed above the source electrode 5, the drain electrode 6 and the TFT channel without forming the protection layer 12.

When the protection layer 12 is formed, the black matrix layer 10 is formed on a portion of the protection layer 12 corresponding to the thin film transistor, and a color resin layer 11 is formed between the surface, which is formed by the protection layer 12 and the black matrix layer 10, and the pixel electrode 7. When the black matrix layer 10 is directly formed on the thin film transistor without forming the protection layer 12, the color resin layer 11 is formed between the surface, which is formed by the gate insulation layer 3 and the black matrix layer 10, and the pixel electrode 7. The protection layer 12 is advantageous to make the pixel region to be more flat.

A storage capacitance bottom electrode 13 formed by the metal material for the gate electrode 2 is further provided in the electrode pattern region. An insulation layer via hole is formed above the storage capacitance bottom electrode 13. The insulation layer via hole penetrates the passivation layer 9, the color resin layer 11, the protection layer 12 (if is formed) and the gate insulation layer 3. The common electrode 8 is connected with the storage capacitance bottom electrode 13 by the insulation layer via hole.

In the present embodiment, the storage capacitance bottom electrode 13 may be a common electrode line (Cst on common) to provide a constant voltage to the common electrode 8, or may be a portion of the gate line (Cst on Gate).

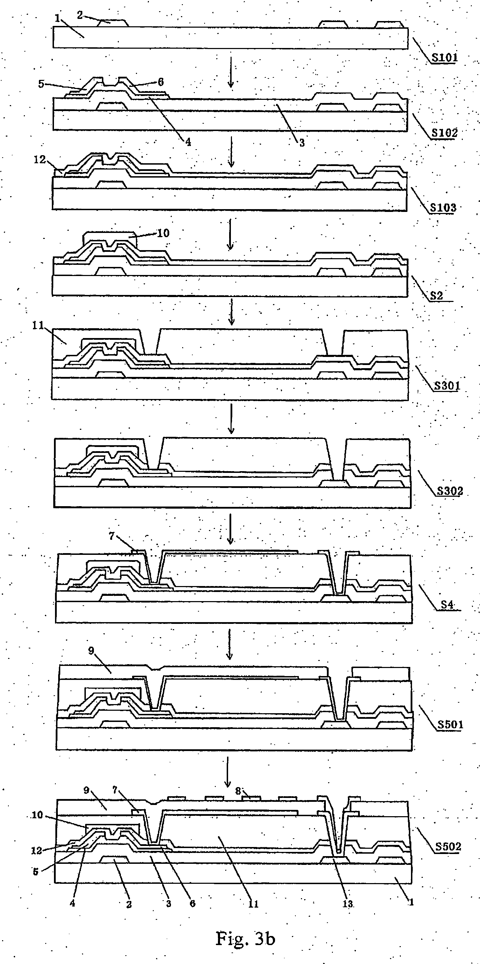

In addition, the present embodiment further provides a method of manufacturing the array substrate. As shown in Figs. 3a and 3b, the method may comprise: firstly forming the gate line, the gate electrode 2, the gate insulation layer 3, the active layer 4, the source electrode 5, the drain electrode 6 and the data line, so as to form the thin film transistor region; subsequently forming the color resin layer 11; and finally forming the pixel electrode 7, the passivation layer 9 and .the common electrode 8, so as to form the electrode pattern region. For example, the method comprises the following steps:
Step S1: firstly forming the gate line, the gate electrode 2, the gate insulation layer 3, the active layer 4, the source electrode 5, the drain electrode 6 and the data line so as to form the thin film transistor region, and subsequently forming the protection layer 12 by an insulation material. The step may comprise the following steps S101, S102 and S103.
Step S101: depositing a first metal layer having conductivity on a substrate and forming the gate line, the gate electrode 2, and the storage capacitance bottom electrode 13 in the electrode pattern region by using a first patterning process;
Step S102: sequentially depositing the gate insulation layer 3 formed by materials such as SiNx, SiON and the like, and a semiconductor active layer 4 formed by materials such as a-Si and the like on the substrate after step S101; depositing a second metal layer having conductivity, and forming the active layer 4, the source electrode 5, the drain electrode 6 and the data line through a second patterning process by using a halftone mask or a gray tone mask so as to form the thin film transistor region;
Step S103: forming the protection layer 12 by using materials such as SiNx and the like on the substrate after step S102 to protect the pixel region.
Step S2: depositing an opaque resin layer on the substrate after the step S1, and forming the black matrix layer 10 at the predetermined position in the thin film transistor region by using a third patterning process.
Step S3: forming the color resin layer 11. The step comprises the following steps S301 and S302:
Step S301: depositing a red resin layer R on the substrate after the step S2 and performing a fourth patterning process, depositing a green resin layer G and a blue resin layer B and performing a fifth patterning process and a sixth patterning process in a manner similar to the red resin layer R, so as to form the color resin layer 11, and etching away the color resin layer 11 above the storage capacitance bottom electrode 13;
Step S302: etching away the gate insulation layer 3 and the protection layer 12 above the storage capacitance bottom electrode 13 by using a seventh patterning process, to expose the storage capacitance bottom electrode 13 and form the insulation layer via hole opened upwardly.
In the following steps S4 and S5, the pixel electrode 7, the passivation layer 9 and the common electrode 8 will be formed. For example, these steps are performed as follows
Step S4: depositing a first transparent conductive layer on the substrate after the step S3, and forming the pixel electrode 7 by using an eighth patterning process;
Step S5: forming the passivation layer 9 and the common electrode 8. The common electrode 8 is connected with the storage capacitance bottom electrode 13 by the insulation layer via hole formed in the above Step S302. The step comprises the following steps S501 and S502:
Step S501: depositing a transparent resin material layer on the substrate after the step S4, and forming the passivation layer 9 by using a ninth patterning process;
Step S502: depositing a second transparent conductive layer on the substrate after the step S501, and forming the common electrode 8 by using a tenth patterning process.
In the above described manufacturing method, the materials for forming the opaque resin layer preferably have a sheet resistance greater than 10¹²Ω/sq, a thickness of 0.5µm∼2µm, and an Optical density (OP) larger than 4.

Preferably, the materials for forming the R,G, and B resin layers have a dielectric constant in the range of 3∼5F/m and a thickness of 1µm∼4µm.

The materials for forming the first and second transparent conductive layers preferably have wet etch selectively in relative to the wiring metal (for example, metal or alloy which has conductivity such as Mo, Al, Ti, Cu and so on), and for example are indium tin oxide (ITO), indium zinc oxide (IZO) and so on. These materials have a good transparency after a treatment of Transparent Conducting Oxide (TCO).

Preferably, the transparent resin material layer for forming the passivation layer 9 have a dielectric constant in a range of 3∼5F/m and a thickness of 1µm∼4µm.

The above opaque resin layer for forming the black matrix layer, the R, G and B resin layers, and the transparent resin material layer for forming the passivation layer may use acrylate, polyimide, epoxy resin, phenol-aldehyde resin and so on as a matrix. The opaque resin layer and the R, G, and B resin layers are formed by adding pigment or dye of different color into the above matrix.

### The Second Embodiment

The present embodiment provides another array substrate. The repetitions of the above first embodiment will be omitted in the present embodiment, and it will give a detailed explanation below on the differences between the present embodiment and the first embodiment.

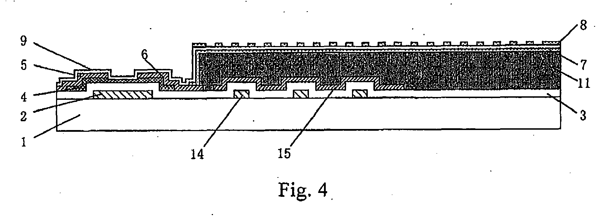

The array substrate provided by the present embodiment may employ the ADS mode. As shown in Fig. 4, the array substrate comprises a gate line and a data line which define a pixel region, and the pixel region comprises a thin film transistor region and an electrode pattern region. A gate electrode 2, a gate insulation layer 3, an active layer 4, a source electrode 5, a drain electrode 6, and a passivation layer 9 are formed in the thin film transistor region. The gate insulation layer 3, a pixel electrode 7, the passivation layer 9 and a common electrode 8 are formed in the electrode pattern region. The common electrode 8 and the pixel electrode 7 may form a multi-dimensional electric field.

A reflective region pattern 14 formed by the metal material for the gate electrode 2 is disposed at the position corresponding to the electrode pattern region on the substrate 1. The gate insulation layer 3 is formed on the reflective region pattern 14. A reflective region metal electrode layer 15 formed of the metal material for the source and drain electrodes is disposed at position corresponding to the reflective region pattern 14 on the gate insulation layer 3. Thus, a trans-reflective array substrate is formed, which may be used under the environment of strong light such as outdoors.

In addition, the present embodiment also provides a method of manufacturing the array substrate. The method comprises the following steps.
Step 1: forming the gate line, the gate electrode 2 and the storage capacitance bottom electrode (not shown) by using a first metal material, and remaining a portion of the first metal material at predetermined positions in the electrode pattern region so as to form a concave-convex pattern by using the first metal material to form the reflective region pattern 14, wherein the first metal material preferably is Al, AlNd, Mo and so on;
   In the present embodiment, the storage capacitance bottom electrode may be a common electrode line (Cst on common) to provide a constant voltage to the common electrode, or may be a portion of the gate line (Cst on Gate).
Step 2: forming the gate insulation layer 3, and forming a semiconductor island by using a semiconductor material to form the active layer 4, wherein the semiconductor material preferably is a-Si, p-Si, IGZO and so on;
Step 3: forming the data line, the source electrode 5 and the drain electrode 6 by using a second metal material, and remaining a portion of the second metal material on the gate insulation layer 3 corresponding to the reflective region pattern 14 to form the reflective region metal electrode layer 15, which is used to achieve the function of a reflective layer, wherein the second metal material preferably is Al, AlNd, Mo and so on;
Steps 4∼6: depositing a red resin layer R and performing a patterning process, and depositing a green resin layer G and a blue resin layer B and performing patterning processes in a manner similar to the red resin layer, so as to form the color resin layer 11;
Step 7: forming the pixel electrode 7 connected with the drain electrode 6 by using a transparent conductive material, wherein the transparent conductive material preferably is ITO, IZO and the like;
Step 8: forming the passivation layer 9 by using an inorganic insulation material, wherein the inorganic insulation material preferably is SiNx, SiOx and the like;
Step 9: forming the common electrode 8 by using a transparent conductive material, wherein the common electrode 8 is connected with the storage capacitance bottom electrode by the via hole (not shown), and the transparent conductive material preferably is ITO, IZO and the like;

Further, the black matrix layer may be subsequently formed on the thin film transistor region on the resultant array substrate by using an opaque resin layer.

It may be understood by those skilled in the art that the pixel electrode may be of a plate shape or a slit shape, and correspondingly, the common electrode may be a slit shape or a plate shape. The stack order of the pixel electrode and the common electrode may be reversed, however, the upper electrode must be of a slit shape, and the lower electrode must be of a plate-shape.

The embodiments of the invention also provide a display device, which comprises the array substrate according to the above embodiments. The display device may be any products or components having display function, such as a liquid crystal panel, an electronic paper, an OLED panel, a liquid crystal TV, a liquid crystal display, a digital photo frame, a cellar phone, a flat panel computer and so on.

## Claims

1. An array substrate, comprising a gate line and a data line which define a pixel region on a substrate (1),
wherein the pixel region comprises a thin film transistor region and an electrode pattern region,
wherein a gate electrode (2), a gate insulation layer (3), an active layer (4), a source electrode (5) and a drain electrode (6), and a passivation layer (9) are sequentially formed from bottom to top in the thin film transistor region on the substrate (1),
wherein a storage capacitance electrode (13), the gate insulation layer (3), a color resin layer (11), a pixel electrode (7), the passivation layer (9), and a common electrode (8) are sequentially formed from bottom to top in the electrode pattern region on the substrate (1), the common electrode (8) and the pixel electrode (7) are configured for forming a multi-dimensional electric field, and the storage capacitance electrode (13) is formed of a metal material for the gate electrode (2) and contacts the substrate (1),
the array substrate further comprising
a via hole, penetrating through the passivation layer (9) between the pixel electrode (7) and the common electrode (8), the color resin layer (11) and the gate insulating layer (3) and formed above the storage capacitance electrode (13);
a first and second transparent conductive pattern formed sequentially in the via hole, the first transparent conductive pattern being formed by a material from which the pixel electrode (7) is formed, and comprising a portion disposed on the color resin layer, and provided in the same layer as the pixel electrode (7), the second transparent conductive pattern being formed by a material from which the common electrode is formed and comprising a portion disposed on the passivation layer and provided in the same layer as the common electrode; wherein
the common electrode (8) is connected with the storage capacitance electrode (13) by the first and second transparent conductive pattern.

2. The array substrate according to Claim 1, wherein
the electrode pattern region further comprises a reflective region and a transmissive region,
a reflective region pattern (14) formed of a metal material for the gate electrode (2) is disposed at a position corresponding to the reflective region of the electrode pattern region on the substrate (1), the gate insulation layer (3) is formed on the reflective region pattern (14); and
a reflective region metal electrode layer (15) formed of a metal material for the source and drain electrodes (5, 6) is disposed at a position corresponding to the reflective region pattern on the gate insulation layer (3).

3. The array substrate according to Claim 1, wherein a protection layer (12) formed of an insulation material is further formed on the source electrode (5), the drain electrode (6) and the gate insulation layer (3) and below the color resin layer (11), a black matrix layer (10) is formed at a position corresponding to the thin film transistor region on the protection layer (12) and below the color resin layer (11), and the via hole further penetrates through the protection layer (12).

4. A method of manufacturing an array substrate, comprising: processes of forming a gate line and a data line defining a pixel region on a substrate (1), wherein the pixel region comprises a thin film transistor region and an electrode pattern region, wherein the method further comprises:
sequentially forming a gate electrode (2), a gate insulation layer (3), an active layer (4), a source electrode (5) and a drain electrode (6), and a passivation layer (9) from bottom to top in the thin film transistor region on the substrate (1), and forming a storage capacitance electrode (13), the gate insulation layer (3), a color resin layer (11), a pixel electrode (7), the passivation layer (9), and a common electrode (8) from bottom to top in the electrode pattern region on the substrate (1), the common electrode (8) and the pixel electrode (7) being configured for forming a multi-dimensional electric field, and the storage capacitance electrode (13) being formed of a metal material for the gate electrode (2) and contacting the substrate (1);
forming a via hole, the via hole penetrating through the passivation layer (9) between the pixel electrode (7) and the common electrode (8), the color resin layer (11) and the gate insulating layer (3) and formed above the storage capacitance bottom electrode (13), and
forming a first transparent conductive pattern in the via hole simultaneously with the pixel electrode (7), forming a second transparent conducting pattern in the via hole simultaneously with the forming of the common electrode thereby connecting the common electrode (8) with the storage capacitance bottom electrode (13), wherein a portion of the first transparent conductive pattern is disposed on the color resin layer and provided in the same layer as the pixel electrode (7), and a portion of the second transparent conductive pattern is disposed on the passivation layer and provided in the same layer as the common electrode

5. The method of manufacturing the array substrate according to Claim 4, wherein the electrode pattern region further comprises a reflective region and a transmissive region, in a process of forming the gate electrode (2), a reflective region pattern (14) formed of a metal material for the gate electrode (2) is disposed at a position corresponding to the reflective region of the electrode pattern region on the substrate (3); and
in a process of forming the source and the drain electrodes (5, 6), a reflective region metal electrode layer (15) formed of a metal material for the source and drain electrodes (5, 6) is disposed at a position corresponding to the reflective region pattern (14) on the gate insulation layer (3).

6. The method of manufacturing the array substrate according to Claim 4, wherein a protection layer (12) formed of an insulation material is formed after forming the source and drain electrodes (5, 6) and before forming the color resin layer, (11), a black matrix layer (10) is formed at a position corresponding to the thin film transistor region on the protection layer (12) and below the color resin layer, and the via hole further penetrates through the protection layer (12).

7. A display device, comprising the array substrate according to any one of Claims 1-3.

## Patentansprüche

1. Array-Substrat mit einer Gate-Leitung und einer Datenleitung, die einen Pixel-Bereich auf einem Substrat (5) definieren,
wobei der Pixel-Bereich einen Dünnschichttransistorbereich und einen Elektrodenstrukturbereich aufweist,
wobei eine Gate-Elektrode (2), eine Gate-Isolierschicht (3), eine Aktivschicht (4), eine Source-Elektrode (5) und eine Drain-Elektrode (6), und eine Passivierungsschicht (9) sequentiell von unten nach oben in dem Dünnschichttransistorbereich auf dem Substrat (1) gebildet sind,
wobei eine Speicherkapazitätselektrode (13), die Gate-Isolierschicht (3), eine Farbharzschicht (11), eine Pixelelektrode (7), die Passivierungsschicht (9) und eine gemeinsame Elektrode (8) sequentiell von unten nach oben in dem Elektrodenstrukturbereich auf dem Substrat (1) gebildet sind, wobei die gemeinsame Elektrode (8) und die Pixelelektrode (7) zum Bilden eines mehrdimensionalen elektrischen Feldes konfiguriert sind und die Speicherkapazitätselektrode (13) aus einem Metallmaterial für die Gate-Elektrode (2) gebildet ist und das Substrat (1) berührt,
wobei das Array-Substrat weiter aufweist
ein Via-Loch, das die Passivierungsschicht (9) zwischen der Pixelelektrode (7) und der gemeinsamen Elektrode, die Farbharzschicht (11) und die Gate-Isolierschicht (3) durchdringt und über der Speicherkapazitätselektrode (13) gebildet ist;
eine erste und eine zweite transparente leitfähige Struktur, die sequentiell in dem Via-Loch gebildet ist, wobei die erste transparente leitfähige Struktur durch ein Material gebildet ist, aus dem die Pixelelektrode (7) gebildet ist, und einen Teil aufweist, der auf der Farbharzschicht angeordnet und in derselben Schicht wie die Pixelelektrode vorgesehen ist, und die zweite transparente leitfähige Struktur durch ein Material gebildet ist, aus dem die gemeinsame Elektrode gebildet ist und einen Teil aufweist, der auf der Passivierungsschicht angeordnet und in derselben Schicht wie die gemeinsame Elektrode vorgesehen ist; wobei
die gemeinsame Elektrode (8) mit der Speicherkapazitätselektrode (13) und der ersten und der zweiten transparenten leitfähigen Struktur verbunden ist.

2. Array-Substrat gemäß Anspruch 1, wobei
der Elektrodenstrukturbereich weiter einen Reflexionsbereich und einen Transmissionsbereich aufweist,
eine Reflexionsbereichsstruktur (14), die aus einem Metallmaterial für die Gate-Elektrode (2) gebildet ist, an einer Position angeordnet ist, die dem Reflexionsbereich des Elektrodenstrukturbereichs auf dem Substrat (1) entspricht, wobei die Gate-Isolierschicht (3) auf der Reflexionsbereichsstruktur (14) gebildet ist; und
eine Reflexionsbereichsmetallelektrodenschicht (15), die aus einem Metallmaterial für die Source- und die Drain-Elektroden (5, 6) gebildet ist, an einer Position angeordnet ist, die der Reflexionsbereichsstruktur auf der Gate-Isolierschicht (3) entspricht.

3. Array-Substrat gemäß Anspruch 1, wobei eine Schutzschicht (12), die aus einem Isoliermaterial gebildet ist, weiter auf der Source-Elektrode (5), der Drain-Elektrode (6) und der Gate-Isolierschicht (3) und unter der Farbharzschicht (11) gebildet ist, eine Schwarzmatrixschicht (10) an einer Position, die dem Dünnschichttransistorbereich entspricht, auf der Schutzschicht (12) und unter der Farbharzschicht (11) gebildet ist, und das Via-Loch weiter die Schutzschicht (12) durchdringt.

4. Herstellungsverfahren für ein Array-Substrat mit: Prozessen zum Bilden einer Gate-Leitung und einer Datenleitung, die einen Pixel-Bereich auf einem Substrat (1) definieren, wobei der Pixel-Bereich einen Dünnschichttransistorbereich und einen Elektrodenstrukturbereich aufweist, wobei das Verfahren weiter aufweist:
sequentielles Bilden einer Gate-Elektrode (2), einer Gate-Isolierschicht (3), einer Aktivschicht (4), einer Source-Elektrode (5) und einer Drain-Elektrode (6) sowie einer Passivierungsschicht (9) von unten nach oben auf dem Substrat (1) in dem Dünnschichttransistorbereich, und Bilden einer Speicherkapazitätselektrode (13), der Gate-Isolierschicht (3), einer Farbharzschicht (11), einer Pixelelektrode (7), der Passivierungsschicht (9) und einer gemeinsamen Elektrode (8) von unten nach oben auf dem Substrat (1) in dem Elektrodenstrukturbereich, wobei die gemeinsame Elektrode (8) und die Pixelelektrode (7) zum Bilden eines mehrdimensionalen elektrischen Feldes konfiguriert sind, und wobei die Speicherkapazitätselektrode (13) aus einem Metallmaterial für die Gate-Elektrode (2) gebildet ist und das Substrat (1) berührt;
Bilden eines Via-Lochs, wobei das Via-Loch die Passivierungsschicht (9) zwischen der Pixelelektrode (7) und der gemeinsamen Elektrode (8), die Farbharzschicht (11) und die Gate-Isolierschicht (3) durchdringt und über der Speicherkapazitätsgrundelektrode (13) gebildet ist, und
Bilden einer ersten transparenten leitfähigen Schicht in dem Via-Loch gleichzeitig mit der Pixelelektrode (7), Bilden einer zweiten transparenten leitfähigen Struktur in dem Via-Loch gleichzeitig mit dem Bilden der gemeinsamen Elektrode dadurch Verbinden der gemeinsamen Elektrode (8) mit der Speicherkapazitätsgrundelektrode (13), wobei ein Teil der ersten transparenten leitfähigen Struktur auf der Farbharzschicht angeordnet und in derselben Schicht wie die Pixelelektrode (7) vorgesehen ist, und ein Teil der zweiten transparenten leitfähigen Struktur auf der Passivierungsschicht angeordnet und in derselben Schicht wie die gemeinsame Elektrode vorgesehen ist.

5. Herstellungsverfahren für ein Array-Substrat gemäß Anspruch 4, wobei
der Elektrodenstrukturbereich weiter aufweist einen Reflexionsbereich und einen Transmissionsbereich,
wobei in einem Prozess zum Bilden der Gate-Elektrode (3) eine Reflexionsbereichsstruktur (14), die aus einem Metallmaterial für die Gate-Elektrode (3) gebildet ist, an einer Position angeordnet wird, die dem Reflexionsbereich des Elektrodenstrukturbereichs auf dem Substrat (2) entspricht; und
wobei in einem Prozess zum Bilden der Source- und die Drain-Elektroden (5, 6) eine Reflexionsbereichsmetallelektrodenschicht (15), die aus einem Metallmaterial für die Source- und die Drain-Elektroden (5, 6) gebildet ist, an einer Position angeordnet wird, welcher der Reflexionsbereichsstruktur (14) auf der Gate-Isolierschicht (3) entspricht.

6. Herstellungsverfahren für das Array-Substrat gemäß Anspruch 4, wobei eine Schutzschicht (12), die aus einem Isoliermaterial gebildet ist, nach Bilden der Source- und der Drain-Elektroden (5, 6) und vor Bilden der Farbharzschicht (11) gebildet wird, eine Schwarzmatrixschicht (10) an einer Position, die dem Dünnschichttransistorbereich entspricht, auf der Schutzschicht (12) und unter der Farbharzschicht gebildet wird, und das Via-Loch weiter die Schutzschicht (12) durchdringt.

7. Anzeigevorrichtung mit dem Array-Substrat gemäß einem der Ansprüche 1 bis 3.

## Revendications

1. Substrat de réseau, comprenant une ligne de grille et une ligne de données, lesquelles définissent une région de pixel sur un substrat (1),
dans lequel la région de pixel comprend une région de transistor à couches minces et une région de motif d'électrode,
dans lequel une électrode de grille (2), une couche d'isolation de grille (3), une couche active (4), une électrode source (5) et une électrode de drain (6), et une couche de passivation (9) sont formées de manière séquentielle du bas vers le haut dans la région de transistor à couches minces sur le substrat (1) ;
dans lequel une électrode de capacité de stockage (13), la couche d'isolation de grille (3), une couche de résine de couleur (11), une électrode de pixel (7), la couche de passivation (9) et une électrode commune (8) sont formées de manière séquentielle du bas vers le haut dans la région de motif d'électrode sur le substrat (1) ; l'électrode commune (8) et l'électrode de pixel (7) sont configurées pour former un champ électrique multidimensionnel, et l'électrode de capacité de stockage (13) est formée d'un matériau métallique pour l'électrode de grille (2) et est en contact avec le substrat (1),
le substrat de réseau comprenant en outre :
un trou d'interconnexion, pénétrant à travers la couche de passivation (9) entre l'électrode de pixel (7) et l'électrode commune (8), la couche de résine de couleur (11) et la couche d'isolation de grille (3), et étant formé au-dessus de l'électrode de capacité de stockage (13) ;
des premier et second motifs conducteurs transparents formés de manière séquentielle dans le trou d'interconnexion, le premier motif conducteur transparent étant formé par un matériau à partir duquel est formée l'électrode de pixel (7) et comprenant une portion disposée sur la couche de résine de couleur et fournie dans la même couche que l'électrode de pixel (7), le second motif conducteur transparent étant formé par un matériau à partir duquel est formée l'électrode commune et comprenant une portion disposée sur la couche de passivation et fournie dans la même couche que l'électrode commune, dans lequel
l'électrode commune (8) est connectée à l'électrode de capacité de stockage (13) par les premier et second motifs conducteurs transparents.

2. Substrat de réseau selon la revendication 1, dans lequel
la région de motif d'électrode comprend en outre une région réflectrice et une région transmissive ;
un motif de région réflectrice (14) formé d'un matériau métallique pour l'électrode de grille (2) est disposé sur une position correspondant à la région réflectrice de la région de motif d'électrode sur le substrat (1), la couche d'isolation de grille (3) est formée sur le motif de région réflectrice (14), et
une couche d'électrode métallique de région réflectrice (15) formée d'un matériau métallique pour les électrodes source et de drain (5, 6) est disposée sur une position correspondant au motif de région réflectrice sur la couche d'isolation de grille (3).

3. Substrat de réseau selon la revendication 1, dans lequel une couche de protection (12) formée d'un matériau isolant est en outre formée sur l'électrode source (5), l'électrode de drain (6) et la couche d'isolation de grille (3) et au-dessous de la couche de résine de couleur (11), une couche de matrice noire (10) est formée sur une position correspondant à la région de transistor à couches minces sur la couche de protection (12) et au-dessous de la couche de résine de couleur (11), et le trou d'interconnexion pénètre en outre à travers la couche de protection (12).

4. Procédé de fabrication d'un substrat de réseau, comprenant : des processus destinés à former une ligne de grille et une ligne de données définissant une région de pixel sur un substrat (1), dans lequel la région de pixel comprend une région de transistor à couches minces et une région de motif d'électrode, dans lequel le procédé comprend en outre les étapes consistant à :
former de manière séquentielle une électrode de grille (2), une couche d'isolation de grille (3), une couche active (4), une électrode source (5) et une électrode de drain (6), et une couche de passivation (9) du bas vers le haut dans la région de transistor à couches minces sur le substrat (1), et former une électrode de capacité de stockage (13), la couche d'isolation de grille (3), une couche de résine de couleur (11), une électrode de pixel (7), la couche de passivation (9) et une électrode commune (8) du bas vers le haut dans la région de motif d'électrode sur le substrat (1), l'électrode commune (8) et l'électrode de pixel (7) étant configurées pour former un champ électrique multidimensionnel, et l'électrode de capacité de stockage (13) étant formée d'un matériau métallique pour l'électrode de grille (2) et étant en contact avec le substrat (1),
former un trou d'interconnexion, le trou d'interconnexion pénétrant à travers la couche de passivation (9) entre l'électrode de pixel (7) et l'électrode commune (8), la couche de résine de couleur (11) et la couche d'isolation de grille (3), et étant formé au-dessus de l'électrode du bas de capacité de stockage (13) ;
former un premier motif conducteur transparent dans le trou d'interconnexion de manière simultanée avec l'électrode de pixel (7), former un second motif conducteur transparent dans le trou d'interconnexion de manière simultanée à la formation de l'électrode commune, connectant ainsi l'électrode commune (8) à l'électrode du bas de capacité de stockage (13), dans lequel une portion du premier motif conducteur transparent est disposée sur la couche de résine de couleur et fournie dans la même couche que l'électrode de pixel (7), et une portion du second motif conducteur transparent est disposée sur la couche de passivation et fournie dans la même couche que l'électrode commune.

5. Procédé de fabrication d'un substrat de réseau selon la revendication 4, dans lequel
la région de motif d'électrode comprend en outre une région réflectrice et une région transmissive ;
dans un processus de formation de l'électrode de grille (2), un motif de région réflectrice (14) formée d'un matériau métallique pour l'électrode de grille (2) est disposé sur une position correspondant à la région réflectrice de la région de motif d'électrode sur le substrat (3), et
dans un processus de formation des électrodes source et de drain (5, 6), une couche d'électrode métallique de région réflectrice (15) formée d'un matériau métallique pour les électrodes source et de drain (5, 6) est disposée sur une position correspondant au motif de région réflectrice (14) sur la couche d'isolation de grille (3).

6. Procédé de fabrication d'un substrat de réseau selon la revendication 4, dans lequel une couche de protection (12) formée d'un matériau isolant est formée après formation des électrodes source et de drain (5, 6) et avant formation de la couche de résine de couleur (11), une couche de matrice noire (10) est formée sur une position correspondant à la région de transistor à couches minces sur la couche de protection (12) et au-dessous de la couche de résine de couleur (11), et le trou d'interconnexion pénètre en outre à travers la couche de protection (12).

7. Dispositif d'affichage, comprenant le substrat de réseau selon l'une quelconque des revendications 1 à 3.
